# FASCICULE DE BREVET EUROPEEN

(11) **EP 3 605 120 B1**
(45) Date de publication et mention de la délivrance du brevet: **03.03.2021**
(21) Numéro de dépôt: 19188614.2
(22) Date de dépôt: 26.07.2019
(51) Int. Cl.: G01R 31/34

(54) **PROCÉDÉ DE DÉTECTION D'UN DÉFAUT MÉCANIQUE D'UNE POMPE ÉLECTRIQUE**
DETEKTIONSVERFAHREN EINES MECHANISCHEN FEHLERS EINER ELEKTRISCHEN PUMPE
METHOD FOR DETECTING A MECHANICAL FAULT IN AN ELECTRIC PUMP

(30) Priorité: 30.07.2018 FR 1857085
(43) Date de publication de la demande: 05.02.2020
(73) Titulaire: Centre Technique Des Industries Mecaniques, 60300 Senlis (FR)
(72) Inventeur: ELTABACH, Mario, 60200 Compiègne (FR); FORGEZ, Christophe, 60200 Compiègne (FR)
(74) Mandataire: Fédit-Loriot

(56) Documents cités:
- WO-A1-2013/006311
- WO-A1-2017/004461
- CN-A- 107 402 350

## Description

L'invention concerne le domaine de la surveillance et du diagnostique des défauts des pompes électriques.

Plus particulièrement l'invention concerne un procédé de détection de défauts mécaniques d'une pompe électrique entraînée par une machine électrique.

Or, un problème connu concerne la maintenance des pompes électriques. En effet, la détection rapide de défauts mécaniques, électriques ou hydrauliques et leur diagnostic jouent un rôle industriel primordial dans des installations industrielles comprenant de telles pompes, afin d'assurer un fonctionnement optimal de ces installations

Des documents pertinents de l'état de la technique sont CN 107 402 350 A, WO 2013/006311 A1 et WO 2017/004461 A1.

En effet, la solution habituelle dans le domaine des pompes électrique consiste à détecter un changement du rendement de la pompe alertant sur une éventuelle défaillance. Une investigation doit alors être menée, impliquant un arrêt de la pompe. Or une telle solution peut nuire au fonctionnement de la chaîne de production concernée, et peut être relativement complexe à mettre en œuvre dans des installations de pompes immergées ou d'accès complexe.

Aussi, un problème qui se pose et que vise à résoudre la présente invention, est de réaliser un contrôle mécanique des pompes et une détection de pannes à faible coût, fiable et relativement simple à mettre en place, en particulier dans des environnements difficiles d'accès, tel que des pompes immergées et/ou en milieu hostile.

A cet effet, on propose un procédé de détection d'un défaut mécanique d'une pompe électrique actionnée par une machine électrique alimentée électriquement par un réseau électrique triphasé,
ledit procédé comprenant :
- Une étape d'acquisition des tensions triphasées et des courants triphasés en entrée de la machine électrique ;
- Une étape de filtrage des tensions et des courants triphasés acquis ;
- Une étape de transformation des tensions et courants acquis dans un repère diphasé ;
- Une étape d'estimation de la phase de l'impédance électrique de ladite machine électrique tournante en fonction desdites tensions et courant transformés ;
- Une étape de calcul d'au moins une valeur représentative de l'évolution temporelle de l'impédance électrique en fonction de ladite phase d'impédance électrique calculée, et
- Une étape de détection d'un défaut de la pompe mécanique comprenant la comparaison de ladite au moins une valeur représentative de l'évolution temporelle de l'impédance électrique calculée avec au moins une valeur de référence prédéterminée.

Ainsi, on peut détecter de manière relativement simple des défauts mécaniques de pompes, uniquement par l'analyse des paramètres d'impédance électriques, notamment la phase et le module des impédances électriques de la machine électrique entraînant la pompe électrique.

Avantageusement et de manière non limitative, ladite valeur représentative de l'évolution temporelle de l'impédance électrique comprend le calcul de la valeur moyenne et/ou de la variance de la phase d'impédance électrique. Ceci permet d'obtenir des paramètres simples et rapides à calculer et permettant d'obtenir des informations relativement pertinentes sur l'évolution des impédances électriques.

Avantageusement et de manière non limitative, pour une pompe volumétrique à piston rotatif excentré, on détecte une mauvaise orientation du cylindre de ladite pompe lorsque, en charge à une vitesse comprise entre 100 rotations par minutes et 800 rotations par minutes, la valeur moyenne et la variance de la phase d'impédance différant respectivement d'une valeur moyenne de référence et d'une variance de référence. Aussi on détecte de manière relativement simple et rapide une mauvaise orientation du cylindre d'une pompe volumétrique à piston rotatif excentré.

Avantageusement et de manière non limitative, lesdites valeurs moyenne de référence et de variance de référence sont prédéterminées en fonction de la vitesse de rotation de ladite pompe à piston excentré. Ainsi, on peut obtenir des valeurs de références relativement simplement et rapidement.

Avantageusement et de manière non limitative, pour une pompe à rotor hélicoïdal excentré, l'étape de calcul comprend le calcul de la variation de la phase de l'impédance électrique, et en ce on détecte un défaut de fonctionnement à sec, lorsque la variation de la phase tend vers une valeur de π/2. Ainsi on peut détecter de manière relativement simple et rapide un fonctionnement à sec d'une pompe à rotor hélicoïdal excentré.

Avantageusement et de manière non limitative, pour une pompe volumétrique à engrenage, l'étape d'estimation comprend en outre l'estimation du module de l'impédance électrique, l'étape de calcul comprenant le calcul de la variation temporelle desdites amplitudes de phases et de module de l'impédance électrique, et on détecte un passage entre un mode de fonctionnement normal à un mode de fonctionnement avec cavitation, en fonction desdites variations temporelles desdites amplitudes de phases et de module de l'impédance électrique calculées. Ainsi, on peut détecter de manière relativement simple et rapide un fonctionnement avec cavitation d'une pompe volumétrique à engrenages.

Avantageusement et de manière non limitative, pour une pompe centrifuge, l'étape de calcul comprend une transformation spectrale de ladite phase de l'impédance électrique estimée, et on détecte un défaut d'alignement de la pompe, par comparaison d'une composante fréquentielle correspondant à deux fois la fréquence de rotation de ladite pompe centrifuge par rapport à une valeur fréquentielle de référence fonction de la vitesse de rotation de la pompe centrifuge. Ainsi, on peut détecter de manière relativement simple et rapide un défaut d'alignement d'une pompe centrifuge.

Avantageusement et de manière non limitative, pour une pompe centrifuge, l'étape d'estimation comprend l'estimation du module de l'impédance électrique, l'étape de calcul comprenant en outre une transformation spectrale dudit module de l'impédance électrique et on détecte un phénomène de cavitation par l'observation spectrale des modules et phases de l'impédance électrique. Ainsi, on peut détecter de manière relativement simple et rapide un phénomène de cavitation pour une pompe centrifuge.

L'invention concerne aussi un dispositif de détection d'un défaut mécanique d'une pompe électrique adapté pour mettre en œuvre un procédé tel que décrit précédemment

L'invention concerne aussi un ensemble de pompage, comprenant une pompe électrique, une machine électrique pour actionner ladite pompe électrique et un dispositif de détection tel que décrit précédemment.

D'autres particularités et avantages de l'invention ressortiront à la lecture de la description faite ci-après de plusieurs modes de réalisation de l'invention, donnés à titre indicatif mais non limitatif, en référence aux dessins annexés sur lesquels :
- la figure 1 est une vue schématique des étapes du procédé selon l'invention ;
- la figure 2 est une représentation schématique des étapes de filtrage et de transformation des courants et des tensions d'entrée de la machine électrique selon un mode de réalisation de l'invention ;
- la figure 3 une un schéma d'une modélisation d'une machine asynchrone pour le calcul de l'impédance électrique selon un mode de réalisation de l'invention ; et
- la figure 4 est une représentation de l'évolution du couple d'une pompe électrique lors d'un fonctionnement à vide, selon le deuxième mode de réalisation de l'invention.

L'invention porte sur un ensemble de pompage comprenant une pompe électrique actionnée par une machine électrique, ici une machine électrique asynchrone, et un dispositif de détection d'un défaut mécanique de la pompe électrique.

Dans cet ensemble, la machine électrique est alimentée électriquement par un réseau électrique triphasé, bien que l'invention ne soit pas limitée à un nombre particulier de phases d'alimentation.

Le dispositif de détection comprend un micro-processeur, un microcontrôleur ou tout autre dispositif adapté, associé à une mémoire de stockage, tel qu'un disque dur, une mémoire flash et/ou une mémoire RAM.

Le dispositif de détection est adapté pour mettre en œuvre un procédé de détection d'un défaut mécanique de la pompe électrique actionnée par la machine électrique.

L'ensemble de pompage comprend aussi des moyens de mesure de paramètres électriques, tel que des moyens de mesure de la tension d'entrée et du courant d'alimentation du réseau électrique triphasé, autrement dit des tensions et courant en entrée de la machine électrique.

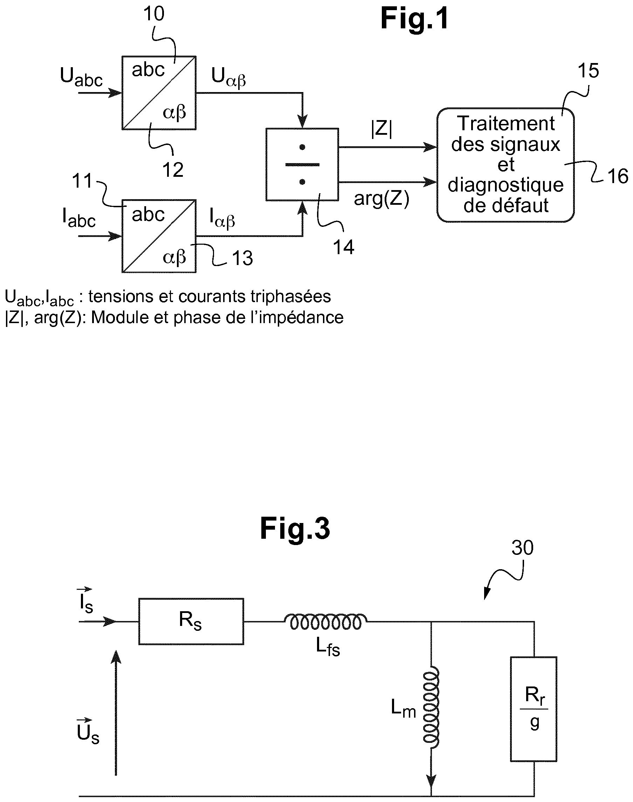

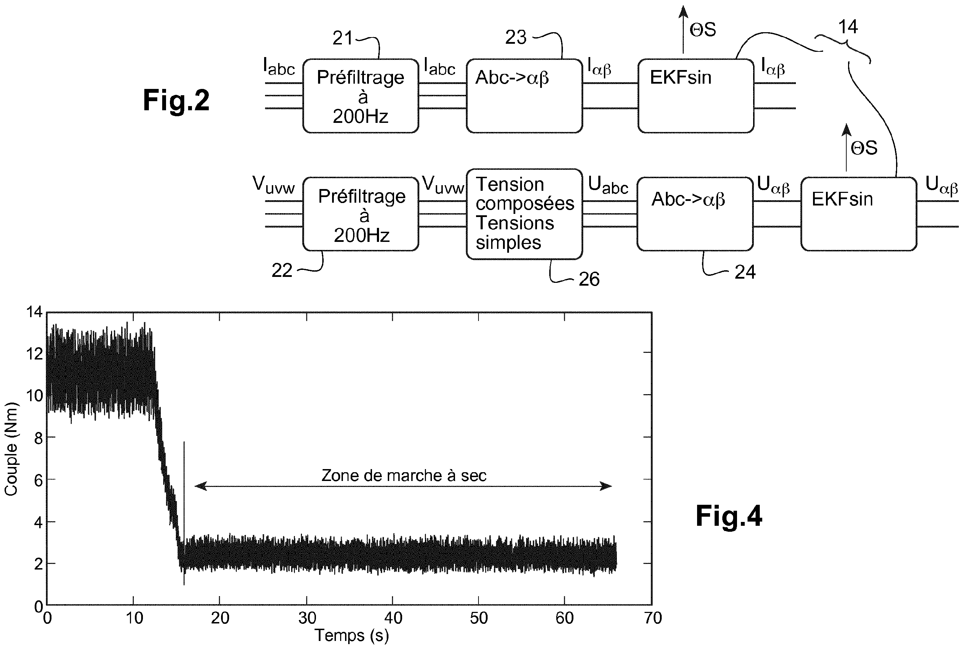

Le procédé selon l'invention, en référence aux figures 1 et 2, comprend tout d'abord une étape d'acquisition 10, 11 comprenant l'acquisition 10 des tensions triphasées V_{uvw} en entrée de la machine électrique et l'acquisition 11 des courants triphasés i_{abc} en entrée de la machine électrique.

Dans le mode de réalisation de l'invention, on procède à l'acquisition 10 des tensions composées V_{uvw} sur le réseau triphasé.

Ensuite on met en œuvre une étape de filtrage 22 des tensions composées V_{uvw}, par un filtrage passe-bas dont la fréquence de coupure est déterminée en fonction des machines électriques et des pompes mises en œuvre, ce qui relève d'un choix bien connu pour l'homme du métier. À titre d'exemple on procède dans ce mode de réalisation à un filtrage passe-bas à une fréquence de coupure de 500Hz.

On procède aussi au filtrage 21 des courants triphasés mesurés, d'une manière identique au filtrage mis en œuvre pour les tensions composées, ici avec un filtre passe-bas à fréquence de coupure de 500Hz.

L'invention n'est pas limitée à un type particulier de filtre passe-bas, bien qu'il soit ici mis en œuvre un filtre passe-bas d'ordre 4.

Ensuite on transforme 26 les tensions composées filtrées en tensions simples filtrées U_{abc}, par la suite appelées plus simplement tensions filtrées U_{abc}.

On transforme 12, 13 ensuite les tensions filtrées U_{abc} et les courants filtrés iabc dans un repère diphasé, par une transformée de Concordia, bien connue de l'homme du métier. Ainsi on obtient des tensions transformées U_{αβ} et courants transformés i_{αβ}.

Une étape de filtrage supplémentaire, selon un mode de réalisation particulier de l'invention, comprend un filtrage connu de l'homme du métier sous le nom de filtrage *EKFsin* par filtre de Kalman des signaux diphasés, tension et courant, afin d'éliminer les éventuels *offsets* liés aux capteurs.

Ensuite, on procède au calcul de l'impédance en fonction des courants et des tensions triphasés selon une méthode comprenant une modélisation de la machine électrique employée, ici une machine asynchrone.

Dans ce mode de réalisation de l'invention on modélise la machine asynchrone par un montage simplifié 30 en référence à la figure 3, comprenant une résistance statorique *Rs* qui représente la résistance des bobinages du stator, une inductance de fuite *Lfs,* une inductance de magnétisation *Lm et* une résistance rotorique *Rr,* avec *g* qui représente le glissement.

Partant d'un tel modèle 30, l'homme du métier est alors apte à calculer l'impédance d'entrée en connaissant en outre les courants diphasés et les tensions diphasées d'entrée.

Une fois l'impédance calculée, on estime 14 alors la phase de l'impédance calculée.

Pour des modes de réalisations particuliers qui seront décrits ci-après, on calcule aussi le module de l'impédance.

Une fois l'étape d'estimation de la phase de l'impédance électrique de la machine électrique calculée, on procède alors à une étape de calcul 15 d'au moins une valeur représentative de l'évolution temporelle de l'impédance électrique en fonction de ladite phase d'impédance électrique calculée, et une étape de détection 16 d'un défaut de la pompe mécanique comprenant la comparaison de ladite au moins une valeur représentative de l'évolution temporelle de l'impédance électrique calculée avec au moins une valeur de référence prédéterminée.

Ces deux étapes de calcul 15 et de détection 16 seront décrites au travers de plusieurs modes de réalisation.

Selon un premier mode de réalisation de l'invention, le procédé est adapté pour une pompe volumétrique à rotor excentré, aussi appelée pompe volumétrique à piston rotatif excentré.

Le principe d'une pompe volumétrique à rotor excentré repose sur le mouvement de translation circulaire d'un piston à l'intérieur d'un cylindre. Le piston, entraîné par un arbre excentré, forme à l'intérieur du cylindre deux chambres étanches. Au cours d'une rotation de l'arbre, les deux chambres évoluent en opposition de phase et passent par les étapes d'aspiration, de transfert et de refoulement.

Une variation de glissement engendre une variation de l'impédance Rr/g : si g augmente Rr/g va tendre vers 0 ce qui, mis en parallèle de l'inductance magnétisante, va contribuer à rendre l'impédance de la machine moins inductive.

Ce raisonnement est d'autant plus vrai que la machine électrique d'entraînement fonctionne à basse vitesse. En effet, à haute vitesse, l'inertie du système va lisser les variations de vitesse et donc de glissement.

Aussi dans ce mode de réalisation la valeur représentative de l'évolution temporelle de l'impédance électrique correspond au calcul de la valeur moyenne et/ou de la variance de la phase d'impédance électrique.

On détecte 16 alors l'éventuelle présence d'un défaut de la pompe volumétrique à rotor excentré, en particulier une mauvaise orientation du cylindre de ladite pompe lorsque, en charge à une vitesse comprise entre 100 rotations par minutes et 800 rotations par minutes, lorsque la valeur moyenne et la variance de la phase d'impédance différent respectivement d'une valeur moyenne de référence et d'une variance de référence.

Ces valeurs de références correspondant à des valeurs prédéterminées, fonction par exemple de la charge de la pompe et de la vitesse de rotation de la pompe, en fonctionnement normal. Ces valeurs de référence pouvant être stockées dans la mémoire du dispositif selon l'invention ou calculées en temps réel par exemple par modélisation numérique.

Selon un deuxième mode de réalisation de l'invention, en référence à la figure 4, le procédé est adapté pour une pompe volumétrique à rotor hélicoïdal excentré

Le défaut étudié pour la pompe à rotor hélicoïdal excentré est un mode de fonctionnement dit « à sec ». Ce défaut apparaît suite à l'absence de liquide dans la pompe ce qui engendre une absence de lubrification et engendre des frottements du rotor hélicoïdal de la pompe sur le stator de cette pompe.

La marche « à sec » peut donc engendrer une détérioration rapide et irréversible de la pompe, sans compter que l'action des frottements peut engendrer de la limaille qui se retrouvera dans le liquide pompé lors du prochain usage normal.

Lors de la transition entre un fonctionnement normal et un fonctionnement en marche à sec, on observe que le niveau du couple mesuré baisse significativement.

Les valeurs de couples lors d'une marche à sec tendent vers un couple minimal ici d'environ 2Nm. Ce couple minimal est celui correspondant aux frottements à vaincre de la pompe sans charge.

Étant donné que le couple final apparaît être le même quel que soit la vitesse, et que celle-ci est constante, ce couple de 2 Nm est assimilé au couple de frottements secs, correspondant au fonctionnement « à sec ».

L'évolution des modules et phases de l'impédance pour ces différents essais de marche à sec, permet donc la détection du changement de fonctionnement de la pompe, ce qui est relativement perceptible sur le module de l'impédance, alors que la phase de l'impédance tend vers une valeur commune d'environ 1.4 rad (soit 80°) ce qui tend vers un fonctionnement purement inductif (p/2) de la machine, synonyme de fonctionnement à vide.

Aussi on détecte un fonctionnement à sec lorsque, pour des fonctionnements à vitesse constante, la phase de l'impédance dépasse la phase d'une valeur de phase prédéterminée, correspondant à un essai nominal, par exemple un essai réalisé sur une machine tournant à 200RPM pour une pression de charge de 2 bars.

Avec un tel procédé, la marche à sec peut être détectée en un temps proche de 5 secondes pour la majorité des cas.
Aussi dans ce deuxième mode de réalisation l'étape de calcul 15 comprend le calcul de la variation de la phase de l'impédance électrique et on détecte 16 le défaut de fonctionnement à sec, lorsque la variation de la phase tend vers une valeur de π/2.

Dans un troisième mode de réalisation de l'invention, pour une pompe volumétrique à engrenage, on détecte un phénomène dit de cavitation de la pompe. Ce mode de fonctionnement est atteint lorsque l'arrivée du liquide à pomper est obturée.

Dans ce mode de réalisation l'étape d'estimation 14 comprend l'estimation de la phase et du module de l'impédance électrique.

L'étape de calcul 15 comprenant le calcul de la variation temporelle desdites amplitudes de phases et de module de l'impédance électrique.

Aussi, on détecte 16 un passage entre un mode de fonctionnement normal à un mode de fonctionnement avec cavitation, en fonction desdites variations temporelles desdites amplitudes de phases et de module de l'impédance électrique calculées, par rapport à des valeurs de référence prédéterminées pouvant être fonction de la vitesse de fonctionnement de la pompe et de sa charge de fonctionnement.

Selon un quatrième mode de réalisation de l'invention concernant une pompe centrifuge, on détecte un phénomène de cavitation tel que décrit précédemment.

Le phénomène de cavitation engendre une sollicitation de la pompe à de multiples fréquences, ce qui se traduit par une augmentation des amplitudes des raies à ces fréquences.

Ce phénomène est visible sur les spectres courants, module et phase de l'impédance électrique et se matérialise par une augmentation d'une large bande fréquentielle entre 500 et 1000Hz.

Aussi dans ce mode de réalisation l'étape de calcul 15 comprend une transformation spectrale de ladite phase de l'impédance électrique estimée.

On détecte alors 16 un défaut d'alignement de la pompe, par comparaison d'une composante fréquentielle correspondant à deux fois la fréquence de rotation de ladite pompe centrifuge par rapport à une valeur fréquentielle de référence fonction de la vitesse de rotation de la pompe centrifuge.

Selon un cinquième mode de réalisation de l'invention, le procédé est aussi adapté pour une pompe centrifuge. Dans ce mode de réalisation, on détecte un défaut d'alignement de la pompe.

Le phénomène de désalignement engendre une sollicitation multiple du double de la fréquence de rotation. Aussi à titre d'exemple, on aperçoit pour un pour un essai réalisé à 1450 rotations par minutes, sur une pompe saine et une autre avec un désalignement de la pompe, respectivement avec des débits respectivement de 935 m³/h sans défaut et de 315 m³/h avec défaut d'alignement, l'émergence d'une raie à 48.3 Hz notamment visible sur le spectre de la phase de l'impédance.

La fréquence de 48.3 Hz correspond à deux fois la fréquence de rotation de la pompe. Cette dernière composante fréquentielle ne subit pas de variation dans le cas du courant ni du module de l'impédance.

Aussi, pour ce mode de réalisation, l'étape d'estimation 14 comprend l'estimation du module de l'impédance électrique.

L'étape de calcul 15 comprend une transformation spectrale dudit module de l'impédance électrique.

Alors on détecte 16 un phénomène de cavitation par l'observation spectrale des modules et phases de l'impédance électrique tel qu'exposé précédemment, en fonction de valeurs du spectre prédéterminées, selon un stockage de données prédéterminées, ou par modélisation de la pompe, en fonction de la vitesse de fonctionnement de la pompe et de la charge de fonctionnement de la pompe.

L'invention n'est toutefois pas limitée à ces modes de réalisation et porte sur l'ensemble des modes de détection de défauts mécaniques de pompes électriques par analyse de l'impédance électrique tel qu'il ressort de la présente description.

## Revendications

1. Procédé de détection d'un défaut mécanique d'une pompe électrique actionnée par une machine électrique alimentée électriquement par un réseau électrique triphasé,
ledit procédé comprenant :
- Une étape d'acquisition (10, 11) des tensions triphasées et des courants triphasés en entrée de la machine électrique ;
- Une étape de filtrage des tensions et des courants triphasés acquis ;
- Une étape de transformation (12, 13) des tensions et courants acquis dans un repère diphasé ;
- Une étape d'estimation (14) de la phase de l'impédance électrique de ladite machine électrique tournante en fonction desdites tensions et courant transformés ;
- Une étape de calcul (15) d'au moins une valeur représentative de l'évolution temporelle de l'impédance électrique en fonction de ladite phase d'impédance électrique calculée, et
- Une étape de détection (16) d'un défaut de la pompe mécanique comprenant la comparaison de ladite au moins une valeur représentative de l'évolution temporelle de l'impédance électrique calculée avec au moins une valeur de référence prédéterminée.

2. Procédé selon la revendication 1, **caractérisé en ce que** ladite valeur représentative de l'évolution temporelle de l'impédance électrique comprend le calcul de la valeur moyenne et/ou de la variance de la phase d'impédance électrique.

3. Procédé selon la revendication 2, pour une pompe volumétrique à piston rotatif excentré, **caractérisé en ce qu'**on détecte (16) une mauvaise orientation du cylindre de ladite pompe lorsque, en charge à une vitesse comprise entre 100 rotations par minutes et 800 rotations par minutes, la valeur moyenne et la variance de la phase d'impédance différant respectivement d'une valeur moyenne de référence et d'une variance de référence.

4. Procédé selon la revendication 3, **caractérisé en ce que** lesdites valeurs moyenne de référence et de variance de référence sont prédéterminées en fonction de la vitesse de rotation de ladite pompe à piston excentré.

5. Procédé selon les revendications 1 ou 2, pour une pompe à rotor hélicoïdal excentré, **caractérisé en ce que** l'étape de calcul (15) comprend le calcul de la variation de la phase de l'impédance électrique, et **en ce qu'**on détecte (16) un défaut de fonctionnement à sec, lorsque la variation de la phase tend vers une valeur de π/2.

6. Procédé selon les revendications 1, pour une pompe volumétrique à engrenage, **caractérisé en ce que** l'étape d'estimation (14) comprend en outre l'estimation du module de l'impédance électrique, l'étape de calcul (15) comprenant le calcul de la variation temporelle desdites amplitudes de phases et de module de l'impédance électrique, et **en ce qu'**on détecte (16) un passage entre un mode de fonctionnement normal à un mode de fonctionnement avec cavitation, en fonction desdites variations temporelles desdites amplitudes de phases et de module de l'impédance électrique calculées.

7. Procédé selon la revendication 1, pour une pompe centrifuge, **caractérisé en ce que** l'étape de calcul (15) comprend une transformation spectrale de ladite phase de l'impédance électrique estimée, et **en ce qu'**on détecte (16) un défaut d'alignement de la pompe, par comparaison d'une composante fréquentielle correspondant à deux fois la fréquence de rotation de ladite pompe centrifuge par rapport à une valeur fréquentielle de référence fonction de la vitesse de rotation de la pompe centrifuge.

8. Procédé selon la revendication 7, **caractérisé en ce que** l'étape d'estimation (14) comprend l'estimation du module de l'impédance électrique, l'étape de calcul (15) comprenant en outre une transformation spectrale dudit module de l'impédance électrique et **en ce qu'**on détecte (16) un phénomène de cavitation par l'observation spectrale des modules et phases de l'impédance électrique.

9. Dispositif de détection d'un défaut mécanique d'une pompe électrique adapté pour mettre en œuvre un procédé selon l'une quelconque des revendications précédentes.

10. Ensemble de pompage, comprenant une pompe électrique, une machine électrique pour actionner ladite pompe électrique et un dispositif de détection selon la revendication 9.

## Patentansprüche

1. Verfahren zur Detektion eines mechanischen Fehlers einer elektrischen Pumpe, die von einer elektrischen Maschine betätigt wird, die durch ein Drehstromnetz elektrisch betrieben wird,
wobei das Verfahren Folgendes umfasst:
- einen Schritt der Erfassung (10, 11) der dreiphasigen Spannungen und dreiphasigen Ströme bei Eintritt in die elektrische Maschine;
- einen Schritt der Filterung der erfassten dreiphasigen Spannungen und Ströme;
- einen Schritt der Transformation (12, 13) der erfassten Spannungen und Ströme in ein Zweiphasen-Koordinatensystem;
- einen Schritt der Ermittlung (14) der Phase der elektrischen Impedanz der rotierenden elektrischen Maschine in Abhängigkeit von den transformierten Spannungen und Strömen;
- einen Schritt der Berechnung (15) mindestens eines Werts, der repräsentativ für die zeitliche Entwicklung der elektrischen Impedanz ist, in Abhängigkeit von der berechneten Phase der elektrischen Impedanz, und
- einen Schritt der Detektion (16) eines Fehlers der mechanischen Pumpe, umfassend das Vergleichen des mindestens einen berechneten Werts, der repräsentativ für die zeitliche Entwicklung der elektrischen Impedanz ist, mit mindestens einem vorgegebenen Referenzwert.

2. Verfahren nach Anspruch 1, **dadurch gekennzeichnet, dass** der Wert, der repräsentativ für die zeitliche Entwicklung der elektrischen Impedanz ist, das Berechnen des Mittelwerts und/oder der Varianz der Phase der elektrischen Impedanz umfasst.

3. Verfahren nach Anspruch 2 für eine Verdrängerpumpe mit exzentrisch angeordnetem Kreis- bzw. Drehkolben, **dadurch gekennzeichnet, dass** eine fehlerhafte Ausrichtung des Zylinders der Pumpe detektiert wird (16), wenn unter Last mit einer Geschwindigkeit zwischen 100 Umdrehungen pro Minute und 800 Umdrehungen pro Minute der Mittelwert und die Varianz der Impedanzphase jeweils von einem Referenzmittelwert und von einer Referenzvarianz abweichen.

4. Verfahren nach Anspruch 3, **dadurch gekennzeichnet, dass** der Referenzmittelwert und der Referenzvarianzwert in Abhängigkeit von der Drehzahl der Pumpe mit exzentrisch angeordnetem Kolben vorgegeben werden.

5. Verfahren nach Anspruch 1 oder 2 für eine Pumpe mit exzentrisch angeordnetem Schraubenrotor, **dadurch gekennzeichnet, dass** der Berechnungsschritt (15) das Berechnen der Veränderung der Phase der elektrischen Impedanz umfasst, und dadurch, dass ein Trockenlauffehler detektiert wird (16), wenn sich die Veränderung der Phase einem Wert von π/2 annähert.

6. Verfahren nach Anspruch 1 für eine Zahnradverdrängerpumpe, **dadurch gekennzeichnet, dass** der Ermittlungsschritt (14) ferner das Ermitteln des Moduls der elektrischen Impedanz umfasst, wobei der Berechnungsschritt (15) das Berechnen der zeitlichen Veränderung der Amplituden der Phasen und des Moduls der elektrischen Impedanz umfasst, und dadurch, dass in Abhängigkeit von den zeitlichen Veränderungen der berechneten Amplituden der Phasen und des Moduls der elektrischen Impedanz ein Übergang aus einem normalen Betriebsmodus in einen Betriebsmodus mit Kavitation detektiert wird (16).

7. Verfahren nach Anspruch 1 für eine Kreiselpumpe, **dadurch gekennzeichnet, dass** der Berechnungsschritt (15) eine Spektraltransformation der ermittelten Phase der elektrischen Impedanz umfasst, und dadurch, dass durch Vergleichen einer Frequenzkomponente, die dem Zweifachen der Rotationsfrequenz der Kreiselpumpe entspricht, mit einem Referenzfrequenzwert in Abhängigkeit von der Drehzahl der Kreiselpumpe eine Fehlausrichtung der Pumpe detektiert wird (16).

8. Verfahren nach Anspruch 7, **dadurch gekennzeichnet, dass** der Ermittlungsschritt (14) das Ermitteln des Moduls der elektrischen Impedanz umfasst, wobei der Berechnungsschritt (15) ferner eine Spektraltransformation des Moduls der elektrischen Impedanz umfasst, und dadurch, dass durch die spektrale Beobachtung der Moduln und Phasen der elektrischen Impedanz ein Kavitationsphänomen detektiert wird (16).

9. Vorrichtung zur Detektion eines mechanischen Fehlers einer elektrischen Pumpe, die dazu ausgelegt ist, ein Verfahren nach einem der vorhergehenden Ansprüche auszuführen.

10. Pumpenanordnung, umfassend eine elektrische Pumpe, eine elektrische Maschine zur Betätigung der elektrischen Pumpe und eine Detektionsvorrichtung nach Anspruch 9.

## Claims

1. A method for detecting a mechanical defect of an electrical pump actuated by an electrical machine electrically supplied by a three-phase electrical supply network,
said method comprising:
a step (10, 11) for sampling the three-phase tensions and three-phase currents at the input of the electrical machine ;
a step for filtering the sampled tensions and three-phase currents ;
a step (12, 13) for transforming the sampled tensions and currents in a two-phase benchmark ;
a step (14) for valuing the phase of the electrical impedance of said electric rotating machine according to said transformed tensions and currents ;
a step (15) for computing at least a value representative of the electrical impedance time evolution according to said calculated electrical impedance phase, and
a step (16) for detecting a defect of the mechanical pump comprising the comparison of said at least one value representative of the calculated electrical impedance time evolution with at least a predetermined reference value.

2. The method according to claim 1, **characterized in that** said value representative of the time evolution of the electrical impedance comprises the calculation of the average value and/or the variance of the electrical impedance phase.

3. The method according to claim 2, for a volumetric pump with rotating eccentric piston, **characterized in that** a bad orientation of the cylinder of said pump is detected (16) when, under load at a speed ranging between 100 rotations per minute and 800 rotations per minute, the average value and the variance of the impedance phase differ respectively from a reference average value and a reference variance.

4. The method according to claim 3, **characterized in that** said reference average value and reference variance are predetermined according to the rotation speed of said pump with an eccentric piston.

5. The method according to claims 1 or 2, for a pump with an eccentric helicoidal rotor, **characterized in that** the computing step (15) comprises the calculation of the electrical impedance phase variation, and **in that** a dry running fault is detected (16) when the phase variation tends towards a value of π/2.

6. The method according to claim 1, for a gear volumetric pump, **characterized in that** the valuing step (14) further comprises the valuation of the electrical impedance module, the computing step (15) comprising the calculation of the time variation of said phase amplitudes and electrical impedance module, and **in that** a change between a normal operating mode to an operating mode with cavitation is detected (16) according to said calculated time variations of said electrical impedance phases and module amplitudes.

7. The method according to claim 1, for a centrifugal pump, **characterized in that** the computing step (15) comprises a spectral transformation of said valued electrical impedance phase, and **in that** a misalignment of the pump is detected (16), by comparison of a frequency component corresponding to the twice of the rotational frequency of said centrifugal pump relatively to a reference frequency value according to the rotational speed of the centrifugal pump.

8. The method according to claim 7, **characterized in that** the valuing step (14) comprises the valuation of the electrical impedance module, the computing step (15) further comprising a spectral transformation of said electrical impedance module and **in that** a cavitation phenomenon is detected (16) by the spectral observation of the modules and phases of the electrical impedance.

9. A device for detecting a mechanical defect of an electrical pump adapted to implement a method according to any of the preceding claims.

10. A pumping assembly, comprising an electrical pump, an electrical machine to actuate said electrical pump and a detecting device according to claim 9.
